# EUROPEAN PATENT APPLICATION

(11) **EP 4 783 294 A1**
(43) Date of publication of application: **29.07.2026**
(21) Application number: 25861728.1
(22) Date of filing: 01.10.2025
(51) Int. Cl.: H01M 10/42, G01R 31/385, G01R 31/392, B25J 11/00, G01N 21/84, G01N 21/88

(54) **POUCH CELL ANALYSIS APPARATUS AND POUCH CELL ANALYSIS METHOD USING SAME**

(30) Priority: 04.12.2024 KR 20240178214
(71) Applicant: LG ENERGY SOLUTION, LTD., Seoul 07335 (KR)
(72) Inventor: LEE, Hye Seong, Daejeon 34122 (KR)
(74) Representative: Goddar, Heinz J.
(86) International application number: PCT/KR2025/095603
(87) International publication number: WO 2026/121938

(57) **Abstract**

Disclosed are a pouch battery cell analysis apparatus and a pouch battery cell analysis method using the same, and more particularly a pouch battery cell analysis apparatus including a measurement unit configured to measure the voltage value of a pouch battery cell, a controller configured to determine whether the pouch battery cell is defective based on the voltage value measured by the measurement unit, a cutting member configured to cut a pouch case of the pouch battery cell, a gripping member configured to grip the pouch case in tight contact with the pouch case, and an analysis unit located above the pouch battery cell, and a pouch battery cell analysis method using the same.

## Description

### [Technical Field]

This application claims the benefit of priority to Korean Patent Application No. 2024-0178214 filed on December 4, 2024, the disclosure of which is incorporated herein by reference in its entirety.

The present invention relates to a pouch battery cell analysis apparatus and a pouch battery cell analysis method using the same, and more particularly to a pouch battery cell analysis apparatus capable of safely disassembling and analyzing a pouch battery cell determined to be defective and a pouch battery cell analysis method using the same.

### [Background Art]

With recent development of alternative energies due to air pollution and energy depletion caused as the result of use of fossil fuels, demand for secondary batteries capable of storing electrical energy that is produced has increased.

Required capacities of secondary batteries used as energy sources of various kinds of electronic devices inevitably used in modern society have been increased due to an increase in usage of mobile devices, increasing complexity of the mobile devices, and development of electric vehicles. In order to satisfy demand of users, a plurality of battery cells is disposed in a small-sized device, whereas a battery module including a plurality of battery cells electrically connected to each other or a battery pack including a plurality of battery modules is used in a vehicle, etc.

Meanwhile, a battery cell may be charged and discharged a plurality of times, and the voltage value of the battery cell is measured to determine whether the battery cell is defective due to short circuit or low voltage.

In addition, the battery cell determined to be defective due to short circuit or low voltage is disassembled by an operator using a cutting knife, etc., and is analyzed to identify the cause of the defect.

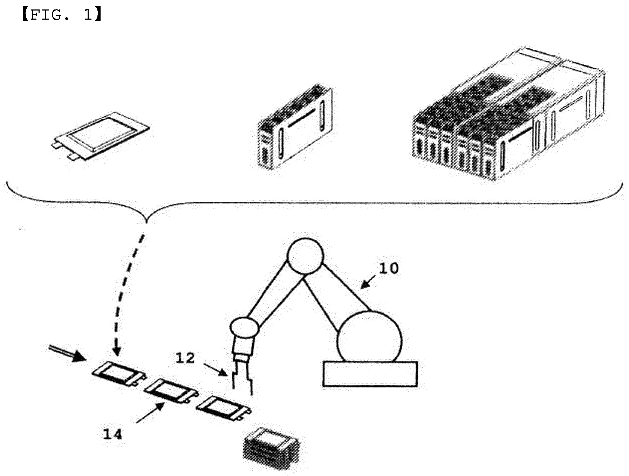

FIG. 1 is a perspective view showing a conventional automatic inspection apparatus. As shown in FIG. 1, the conventional automatic inspection apparatus includes a machine 10 constituted by a robotic device and a test tool 12 configured to measure the voltage of a battery cell 14 in contact therewith.

In the conventional automatic inspection apparatus, the machine 10 brings the test tool 12 into contact with an electrode lead of the battery cell 14, and the voltage value of the battery cell 14 is measured to determine whether the battery cell is defective.

If the battery cell 14 is determined to be defective, an operator cuts a pouch case using a cutting knife, etc. and analyzes the state of an electrode assembly and an electrode tab in the pouch case to identify the cause of the defect.

However, during conventional disassembly and analysis performed to determine whether the battery cell is defective, there is a risk of safety incidents such as heat generation and ignition.

Furthermore, the operator performing repetitive tasks, such as disassembly and analysis, may experience fatigue, hindering accurate disassembly and analysis.

### (Prior Art Document)

(Patent Document 1) Korean Registered Patent Publication No. 1939966

### [Disclosure]

### [Technical Problem]

The present invention has been made in view of the above problems, and it is an object of the present invention to provide a pouch battery cell analysis apparatus capable of disassembling and analyzing a pouch battery cell determined to be defective through a device, thereby preventing a safety incident involving an operator, and a pouch battery cell analysis method using the same.

It is another object of the present invention to provide a pouch battery cell analysis apparatus capable of disassembling and analyzing a pouch battery cell through a device, thereby accurately and rapidly performing the disassembly and analysis process, and a pouch battery cell analysis method using the same.

### [Technical Solution]

A pouch battery cell analysis apparatus according to the present invention to accomplish the above objects includes a controller (200) configured to determine whether a pouch battery cell is defective based on the voltage value measured by a measurement unit (100), a cutting member (300) configured to cut a pouch case of the pouch battery cell (C), a gripping member (400) configured to grip the pouch case in tight contact with the pouch case, and an analysis unit (500) located above the pouch battery cell (C), the analysis unit being configured to analyze a defective state of the pouch battery cell.

Also, in the pouch battery cell analysis apparatus according to the present invention, the cutting member may be a robotic arm provided with a blade head (310).

Also, in the pouch battery cell analysis apparatus according to the present invention, the gripping member (400) may be a robotic arm provided with a suction head (410).

Also, in the pouch battery cell analysis apparatus according to the present invention, the gripping member (400) may be connected to an air pump (600) configured to supply and suction air.

Also, in the pouch battery cell analysis apparatus according to the present invention, the analysis unit (500) may be a vision camera configured to capture an image of the pouch battery cell (C).

Also, in the pouch battery cell analysis apparatus according to the present invention, the blade head (310) may be detachable.

In addition, a pouch battery cell analysis method according to the present invention includes a first step of measuring the voltage value of a pouch battery cell, a second step of determining whether the pouch battery cell is defective based on the measured voltage value, a third step of disassembling the pouch battery cell upon determining that the pouch battery cell is defective, and a fourth step of capturing an image of the disassembled pouch battery cell and analyzing the pouch battery cell based on the image.

Also, in the pouch battery cell analysis method according to the present invention, the second step of determining whether the pouch battery cell is defective based on the measured voltage value may be a step of determining whether the pouch battery cell is defective by comparing the measured voltage value with a normal voltage value according to existing data.

Also, in the pouch battery cell analysis method according to the present invention, if the measured voltage value is lower than the normal voltage value and higher than 0, the pouch battery cell may be determined to be defective due to low voltage.

Also, in the pouch battery cell analysis method according to the present invention, if the pouch battery cell is determined to be defective due to low voltage, a part of the pouch case corresponding to a position of the pouch battery cell at which an electrode assembly is received may be preferentially cut.

Also, in the pouch battery cell analysis method according to the present invention, the electrode assembly may be constituted by at least one unit cell and a bi-cell stacked on the uppermost side of the unit cell, and the gripping member may sequentially separate and disassemble components constituting the electrode assembly, starting with an uppermost component, and at the same time analysis may be performed through the analysis unit.

Also, in the pouch battery cell analysis method according to the present invention, the component may be any one of a separator, a positive electrode, and a negative electrode constituting the unit cell and the bi-cell.

Also, in the pouch battery cell analysis method according to the present invention, if the measured voltage value is 0, the pouch battery cell may be determined to be defective due to short circuit.

Also, in the pouch battery cell analysis method according to the present invention, if the pouch battery cell is determined to be defective due to short circuit, a terrace portion of the pouch case adjacent to a part of the pouch battery cell at which an electrode tab and an electrode lead are connected to each other may be preferentially cut.

### [Advantageous Effects]

As is apparent from the above description, a pouch battery cell analysis apparatus according to the present invention and a pouch battery cell analysis method using the same have the advantage that a pouch battery cell is disassembled through a cutting member and a gripping member, each of which is constituted by a robotic arm, and is analyzed through an analysis unit, which is constituted by a vision camera, whereby it is possible to prevent a safety incident involving an operator.

In addition, the pouch battery cell analysis apparatus according to the present invention and the pouch battery cell analysis method using the same have the advantage that a pouch battery cell determined to be defective is automatically disassembled and analyzed, whereby it is possible to perform rapid and accurate disassembly and analysis.

### [Description of Drawings]

FIG. 1 is a perspective view showing a conventional automatic inspection apparatus.
FIG. 2 is a perspective view showing a pouch battery cell analysis apparatus according to a preferred embodiment of the present invention.
FIG. 3 is a flowchart showing a pouch battery cell analysis method according to a preferred embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, a pouch battery cell analysis apparatus according to the present invention and a pouch battery cell analysis method using the same will be described with reference to the accompanying drawings.

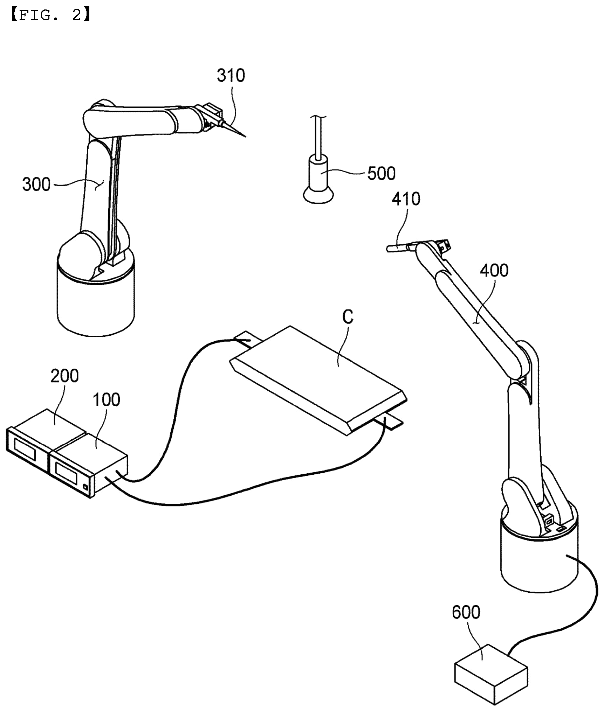

FIG. 2 is a perspective view showing a pouch battery cell analysis apparatus according to a preferred embodiment of the present invention.

Referring to FIG. 2, the pouch battery cell analysis apparatus according to the preferred embodiment of the present invention includes a measurement unit 100, a controller 200, a cutting member 300, a gripping member 400, an analysis unit 500, and an air pump 600.

First, the measurement unit 100 is configured to measure the voltage value of a pouch battery cell C, and is connected to electrode leads of the pouch battery cell C, which are constituted by a negative electrode lead and a positive electrode lead.

In addition, the measurement unit 200 transmits the measured voltage value of the pouch battery cell C to the controller 200.

Here, the pouch battery cell C includes an electrode assembly, a pouch case configured to receive the electrode assembly, and electrode leads protruding outward from the pouch case.

The electrode assembly is configured to have a structure in which positive electrodes and negative electrodes are alternately stacked a plurality of times in the state in which separators are interposed therebetween, and a pair of electrode leads constituted by a positive electrode lead and a negative electrode lead is exposed to the outside of the pouch case in a state of being electrically connected to positive tabs and negative tabs, respectively.

The positive electrode is manufactured by applying a positive electrode mixture including a positive electrode active material to a positive electrode current collector and drying the same, and the positive electrode mixture may optionally further include a binder, a conductive agent, or a filler, as needed.

In general, the positive electrode current collector may have a thickness of 3 to 500 µm. The positive electrode current collector is not particularly restricted as long as the positive electrode current collector exhibits high conductivity while the positive electrode current collector does not induce any chemical change in a battery to which the positive electrode current collector is applied. For example, the positive electrode current collector may be made of stainless steel, aluminum, nickel, titanium, or sintered carbon. Alternatively, the positive electrode current collector may be made of aluminum or stainless steel, the surface of which is treated with carbon, nickel, titanium, or silver. In addition, the positive electrode current collector may have a micro-scale uneven pattern formed on the surface thereof so as to increase adhesion of the positive electrode active material, or may be configured in any of various forms, such as a film, a sheet, a foil, a net, a porous body, a foam body, and a non-woven fabric body.

A layered compound, such as lithium cobalt oxide (LiCoO₂) or lithium nickel oxide (LiNiO₂), or a compound substituted with one or more transition metals; a lithium manganese oxide represented by the chemical formula Li₁₊ₓMn_{2- x}O₄ (where x = 0 to 0.33) or a lithium manganese oxide, such as LiMnO₃, LiMn₂O₃, or LiMnO₂; lithium copper oxide (Li₂CuO₂); a vanadium oxide, such as LiV₃O₈, V₂O₅, or Cu₂V₂O₇; a Ni-sited lithium nickel oxide represented by the chemical formula LiNi₁₋ₓMₓO₂ (where M = Co, Mn, Al, Cu, Fe, Mg, B, or Ga, and x = 0.01 to 0.3); a lithium manganese composite oxide represented by the chemical formula LiMn₂₋ₓMₓO₂ (where M = Co, Ni, Fe, Cr, Zn, or Ta, and x = 0.01 to 0.1) or the chemical formula Li₂Mn₃MO₈ (where M = Fe, Co, Ni, Cu, or Zn); LiMn₂O₄ in which a part of Li in the chemical formula is replaced by alkaline earth metal ions; a disulfide compound; or Fe₂(MoO₄)₃ may be used as the positive electrode active material; however, the present invention is not limited thereto.

The negative electrode is manufactured by applying a negative electrode mixture including a negative electrode active material to a negative electrode current collector and drying the same, and the negative electrode mixture may further include a component, such as a conductive agent, a binder, or a filler, as needed.

The negative electrode current collector is generally manufactured so as to have a thickness of 3 to 500 µm. The negative electrode current collector is not particularly restricted as long as the negative electrode current collector exhibits high conductivity while the negative electrode current collector does not induce any chemical change in a battery to which the negative electrode current collector is applied. For example, the negative electrode current collector may be made of copper, stainless steel, aluminum, nickel, titanium, or sintered carbon. Alternatively, the negative electrode current collector may be made of copper or stainless steel, the surface of which is treated with carbon, nickel, titanium, or silver, or an aluminum-cadmium alloy. Furthermore, in the same manner as the positive electrode current collector, the negative electrode current collector may have a micro-scale uneven pattern formed on the surface thereof in order to increase adhesion of the negative electrode active material, or may be configured in any of various forms, such as a film, a sheet, a foil, a net, a porous body, a foam body, and a non-woven fabric body.

The separator prevents short circuit between the negative electrode and the positive electrode and allows only migration of lithium ions, and an insulating thin film having high ion permeability and mechanical strength is used as the separator. The pore diameter of the separator is typically 0.01 to 10 µm, and the thickness of the separator is typically 5 to 300 µm. It is preferable for the separator to be made of any one selected from among polyethylene, polypropylene, a dual layer of polyethylene/polypropylene, a triple layer of polyethylene/polypropylene/polyethylene, a triple layer of polypropylene/polyethylene/polypropylene, and organic fiber filter paper; however, the present invention is not limited thereto.

Meanwhile, each of the negative electrode current collector and the positive electrode current collector includes a part to which a slurry mixture including the active material is applied and an uncoated portion, which is a part to which no slurry mixture is applied, wherein the uncoated portion is cut to form an electrode tab, or a separate conductive member is connected to the uncoated portion by ultrasonic welding to form an electrode tab, and electrode tabs are gathered to form an electrode tab bundle.

The pouch case may be made of a laminate sheet including an inner covering layer, a metal layer, and an outer covering layer, and may be provided with a pocket portion configured to receive the electrode assembly and an edge portion extending outward from one side of the pocket portion by a predetermined length.

The inner covering layer is in direct contact with the electrode assembly, and therefore the inner covering layer must exhibit high insulation properties and high electrolytic resistance. In addition, the inner covering layer must exhibit high sealability in order to hermetically isolate the pouch case from the outside, i.e., a thermallybonded sealed portion between inner layers must exhibit excellent thermal bonding strength.

The inner covering layer may be made of a material selected from among a polyolefin-based resin, such as polypropylene, polyethylene, polyethylene acrylic acid, or polybutylene, a polyurethane resin, and a polyimide resin, which exhibit excellent chemical resistance and high sealability; however, the present invention is not limited thereto, and polypropylene, which exhibits excellent mechanical properties, such as tensile strength, rigidity, surface hardness, and impact resistance, and excellent chemical resistance, is the most preferably used.

The metal layer, which abuts the inner covering layer, corresponds to a blocking layer configured to prevent moisture or various gases from permeating into the battery from the outside. An aluminum thin film, which is lightweight and easily shapeable, may be used as a preferred material for the metal layer.

The outer covering layer is provided on the other surface of the metal layer, and the outer covering layer may be made of a heat-resistant polymer that exhibits excellent tensile strength, resistance to moisture permeation, and resistance to air transmission such that the outer covering layer exhibits high heat resistance and chemical resistance while protecting the electrode assembly. As an example, the outer covering layer may be made of nylon or polyethylene terephthalate; however, the present invention is not limited thereto.

In general, the pair of electrode leads, which is constituted by the positive electrode lead and the negative electrode lead, is connected respectively to the electrode tab bundles, more specifically a positive electrode tab bundle and a negative electrode tab bundle, by welding or the like, and protrudes outwardly of the pouch case.

Next, the controller 200, located on one side of the measurement unit 100, is configured to determine whether the pouch battery cell C is defective based on the voltage value received from the measurement unit 100.

Although the figure shows that the controller 200 is provided separately on one side of the measurement unit 100, the controller 200 may be integrated with the measurement unit 100 to form a single unit.

The cutting member 300 is configured to cut the pouch case of the pouch battery cell C determined to be defective such that the pouch battery cell is disassembled, and a blade head 310 is provided at an end thereof.

The cutting member 300 may be constituted by a robotic arm, and the movement of the cutting member is free enough to cut the pouch case of the pouch battery cell C using the blade head 310.

In this case, the blade head 310 may be detachably attached to the cutting member 300, whereby replacement of the blade head is possible when the blade head 310 wears down due to repeated use, causing the cutting function thereof to deteriorate.

Meanwhile, the gripping member 400 is configured to grip a part of the pouch case when the pouch case is cut using the cutting member 300, and a suction head 410 is provided at an end thereof.

The gripping member 400 may be constituted by a robotic arm, and the movement of the gripping member is free enough to grip a part of the entire surface of the pouch case using the suction head 410.

In this case, the suction head 410 may be detachably attached to the gripping member 400.

Suction heads 410 of different sizes are used according to the suction force required during gripping and the gripping area, and may be detachably attached the gripping member 400.

In addition, the gripping member 400 may grip components located above the electrode assembly received in the pouch case when the pouch case is cut by the cutting member 300, whereby it is possible to separate the gripped components from the electrode assembly.

The analysis unit 500 is configured to analyze the electrode assembly, electrode tabs, or the electrode leads of the pouch battery cell C disassembled by the cutting member 300 and the gripping member 400, and may be constituted by a vision camera capable of capturing an image.

The analysis unit 500 may be located above the pouch battery cell C so as to be spaced apart therefrom, and is configured to be movable, whereby the position of the analysis unit is adjusted according to the movement radius of the cutting member 300 and the gripping member 400.

Meanwhile, the air pump 600 is connected to the suction head 410 of the gripping member 400 to suction and supply air such that the suction head 410 is gripped and the gripped state of the suction head is released.

The air pump 600 may be provided with an air hose configured to suction and supply air.

One side of the air hose may be connected to the air pump 600, and the other side of the air hose may be connected to suction head 410 through the gripping member 400.

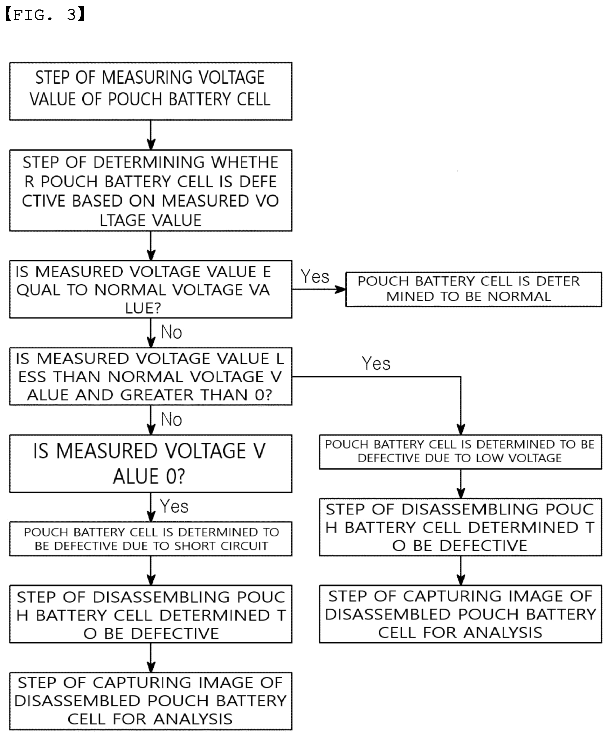

FIG. 3 is a flowchart showing a pouch battery cell analysis method according to a preferred embodiment of the present invention.

Referring to FIG. 3, the pouch battery cell analysis method according to the preferred embodiment of the present invention includes a first step of measuring the voltage value of a pouch battery cell, a second step of determining whether the pouch battery cell is defective based on the measured voltage value, a third step of disassembling the pouch battery cell upon determining that the pouch battery cell is defective, and a fourth step of capturing an image of the disassembled pouch battery cell and analyzing the pouch battery cell based on the image.

The first step of measuring the voltage of the pouch battery cell is a step of connecting the measurement unit to electrode leads of the pouch battery cell to measure the voltage value of the pouch battery cell.

At this time, the measurement unit transmits the measured voltage value of the pouch battery cell to the controller configured to determine whether the pouch battery cell is defective.

The second step of determining whether the pouch battery cell is defective based on the measured voltage value is a step of determining whether the pouch battery cell is defective based on the voltage value received from the measurement unit.

More specifically, the controller compares the measured voltage value with the voltage value of a normal pouch battery cell stored previously therein to determine whether the pouch battery cell is defective.

If the measured voltage value is equal to the voltage value of the normal pouch battery cell, the controller determines that the measured pouch battery cell is normal.

If the measured voltage value is lower than the voltage value of the normal pouch battery cell and greater than 0, the controller determines that the measured pouch battery cell is defective due to low voltage.

Furthermore, if the measured voltage value is 0, the controller determines that the measured pouch battery cell is defective due to short circuit.

The third step of disassembling the pouch battery cell upon determining that the pouch battery cell is defective is a step of disassembling the pouch battery cell using the cutting member and the gripping member based on the defect determined in the second step.

More specifically, if the pouch battery cell is determined to be defective due to low voltage based on the measured voltage value, a part of the pouch case corresponding to a part of the pouch battery cell in which the electrode assembly is provided is cut using the cutting member.

At this time, cutting may be performed in the state in which a part to be cut is gripped by the gripping member.

Here, the gripping member moves upward a predetermined distance in a state of gripping the part to be cut such that the pouch case and the electrode assembly are spaced apart from each other. In this state, cutting is performed. This prevents damage to the electrode assembly by the blade head during cutting.

After cutting is completed, the gripping member moves the cut part of the pouch case to expose the electrode assembly received in the pouch case.

At this time, the electrode assembly is constituted by at least one unit cell and a bi-cell located on the uppermost side of the unit cell.

After gripping of the cut part of the pouch case is released, the gripping member sequentially separates and disassembles the components constituting the electrode assembly, starting with the uppermost component.

Here, the uppermost component may be any one of a separator, a positive electrode, and a negative electrode constituting the unit cell and the bi-cell. As an example, the uppermost bi-cell is disassembled by gripping and separating the uppermost bi-cell in the order of a separator, a negative electrode, and a separator from above.

In addition, after the bi-cell is separated and disassembled, the unit cell is disassembled by gripping and separating unit cell in the order of a positive electrode, a separator, a negative electrode, and a separator from above.

That is, the separators, the negative electrodes, and the positive electrodes are separated from each other for disassembly in order to check the state of the components constituting the electrode assembly.

Meanwhile, if the measured voltage value is 0 and the pouch battery cell is determined to be defective due to short circuit, a terrace portion of the pouch case adjacent to the part at which the electrode tab and the electrode lead are connected to each other is preferentially cut using the cutting member in the state in which the part to be cut is suctioned and gripped through the gripping member.

At this time, cutting may be performed after the gripping member moves upward a predetermined distance in a state of gripping the pouch case.

This is performed to further increase the distance between the pouch case and the electrode tab, preventing damage to the electrode tab and electrode lead by the blade head during cutting of the pouch case.

The fourth step of capturing the image the disassembled pouch battery cell and analyzing the pouch battery cell based on the image is a step of capturing an image of the internal state of the pouch case through the analysis unit located above the pouch battery cell so as to be spaced apart therefrom and analyzing the pouch battery cell based on the image.

More specifically, after the pouch battery cell is determined to be defective due to low voltage and the components of the electrode assembly are separated and disassembled through the gripping member, an image of the state of the separator, the positive electrode, and the negative electrode is captured by the analysis unit, which is constituted by a vision camera.

Based on the image and photograph captured by the analysis unit, whether lithium plating has occurred, the position at which lithium plating has occurred, and whether the positive electrode, the negative electrode, and the separator are damaged are analyzed to derive the cause of the pouch battery cell defect due to low voltage.

In addition, the analysis unit may capture an image of the electrode tab and the electrode lead to analyze whether the electrode tab is damaged and whether electrode lead is damaged.

Meanwhile, if the pouch battery cell is determined to be defective due to short circuit, the cut parts of the pouch case are separated from each other through the gripping member such that the part at which the electrode tab and the electrode lead are formed can be seen outside, and an image of the electrode tab and the electrode lead is captured through the analysis unit to determine whether short circuit has occurred in the electrode tab or the electrode lead.

Those skilled in the art to which the present invention pertains will appreciate that various applications and modifications are possible within the category of the present invention based on the above description.

### (Description of Reference Numerals)

- 100:: Measurement unit
- 200:: Controller
- 300:: Cutting member
- 310:: Blade head
- 400:: Gripping member
- 410:: Suction head
- 500:: Analysis unit
- 600:: Air pump
- C:: Pouch battery cell

## Claims

1. A pouch battery cell analysis apparatus comprising:
a measurement unit configured to measure a voltage value of a pouch battery cell;
a controller configured to determine whether the pouch battery cell is defective based on the voltage value measured by the measurement unit;
a cutting member configured to cut a pouch case of the pouch battery cell;
a gripping member configured to grip the pouch case in tight contact with the pouch case; and
an analysis unit located above the pouch battery cell, the analysis unit being configured to analyze a defective state of the pouch battery cell.

2. The pouch battery cell analysis apparatus according to claim 1, wherein the cutting member is a robotic arm provided with a blade head.

3. The pouch battery cell analysis apparatus according to claim 2, wherein the gripping member is a robotic arm provided with a suction head.

4. The pouch battery cell analysis apparatus according to claim 3, wherein the gripping member is connected to an air pump configured to supply and suction air.

5. The pouch battery cell analysis apparatus according to claim 2, wherein the analysis unit is a vision camera configured to capture an image of the pouch battery cell.

6. The pouch battery cell analysis apparatus according to claim 2, wherein the blade head is detachable.

7. A pouch battery cell analysis method using the pouch battery cell analysis apparatus according to any one of claims 1 to 6, the pouch battery cell analysis method comprising:
a first step of measuring a voltage value of a pouch battery cell;
a second step of determining whether the pouch battery cell is defective based on the measured voltage value;
a third step of disassembling the pouch battery cell upon determining that the pouch battery cell is defective; and
a fourth step of capturing an image of the disassembled pouch battery cell and analyzing the pouch battery cell based on the image.

8. The pouch battery cell analysis method according to claim 7, wherein the second step of determining whether the pouch battery cell is defective based on the measured voltage value is a step of determining whether the pouch battery cell is defective by comparing the measured voltage value with a normal voltage value according to existing data.

9. The pouch battery cell analysis method according to claim 8, wherein, if the measured voltage value is lower than the normal voltage value and higher than 0, the pouch battery cell is determined to be defective due to a low voltage.

10. The pouch battery cell analysis method according to claim 9, wherein, if the pouch battery cell is determined to be defective due to the low voltage, a part of the pouch case corresponding to a position of the pouch battery cell at which an electrode assembly is received is preferentially cut.

11. The pouch battery cell analysis method according to claim 10, wherein
the electrode assembly is constituted by at least one unit cell and a bi-cell stacked on an uppermost side of the unit cell, and
the gripping member sequentially separates and disassembles components constituting the electrode assembly, starting with an uppermost component, and at the same time analysis is performed through the analysis unit.

12. The pouch battery cell analysis method according to claim 11, wherein the component is any one of a separator, a positive electrode, and a negative electrode constituting the unit cell and the bi-cell.

13. The pouch battery cell analysis method according to claim 8, wherein, if the measured voltage value is 0, the pouch battery cell is determined to be defective due to short circuit.

14. The pouch battery cell analysis method according to claim 13, wherein, if the pouch battery cell is determined to be defective due to short circuit, a terrace portion of the pouch case adjacent to a part of the pouch battery cell at which an electrode tab and an electrode lead are connected to each other is preferentially cut.
